# EUROPEAN PATENT APPLICATION

(11) **EP 4 471 416 A1**
(43) Date of publication of application: **04.12.2024**
(21) Application number: 22923998.3
(22) Date of filing: 05.10.2022
(51) Int. Cl.: G01N 27/30, C01B 32/25

(54) **LAMINATED STRUCTURE FOR ELECTRODES, AND METHOD FOR PRODUCING LAMINATED STRUCTURE FOR ELECTRODES**

(30) Priority: 26.01.2022 JP 2022010312
(71) Applicant: Sumitomo Chemical Company, Limited, Tokyo 103-6020 (JP)
(72) Inventor: MORITA, Toshiaki, Hitachi-shi, Ibaraki 319-1418 (JP); KURIHARA, Kaori, Hitachi-shi, Ibaraki 319-1418 (JP)
(74) Representative: Vossius & Partner Patentanwälte Rechtsanwälte mbB
(86) International application number: PCT/JP2022/037222
(87) International publication number: WO 2023/145140

(57) **Abstract**

The present disclosure involves a substrate having conductivity and an electrode film provided on one main surface from among two main surfaces of the substrate and constituted from a diamond crystal containing boron, wherein an interface layer containing carbon as a main component and containing boron is provided between the substrate and the electrode film, and the interface layer has a boron concentration higher than a boron concentration in the electrode film.

## Description

### TECHNICAL FIELD

The present disclosure relates to an electrode-use stack structure and a method of manufacturing an electrode-use stack structure.

### BACKGROUND ART

An electrode-use stack structure including a substrate and an electrode film provided on the substrate and constituted from diamond crystals has a wide potential window and a small background current. Therefore, with such an electrode-use stack structure, electrochemical detection of various substances such as uric acid can be performed with high sensitivity, electrochemical electrolytic treatment such as water treatment or sewage treatment can be performed with high efficiency, and electrochemical ozone generation treatment can be performed with high efficiency. As such, in recent years, it has been proposed to use the above mentioned electrode-use stack structure for electrochemical electrodes such as working electrodes for electrochemical sensors, electrolytic electrodes used for sewage treatment or the like, or ozone generating electrodes (see, for example, Patent Documents 1 to 3).

### PRIOR ART DOCUMENT

### PATENT DOCUMENT

Patent Document 1: Japanese Patent Laid-Open Publication No. 2020-144116
Patent Document 2: Japanese Patent Laid-Open Publication No. 2004-35908
Patent Document 3: Japanese Patent Laid-Open Publication No. 2019-23326

### SUMMARY

### PROBLEMS TO BE SOLVED BY THE DISCLOSURE

The above mentioned electrode-use stack structure is configured to extract, from the substrate side, a current caused by an electrochemical reaction generated on the surface of the electrode film. Therefore, a series resistance between the substrate and the electrode film is required to be low. An objective of the present disclosure is to provide an electrode-use stack structure having a low series resistance between a substrate and an electrode film constituted from diamond crystals containing boron.

### MEANS FOR SOLVING PROBLEM

According to an aspect of the present disclosure, there is provided an electrode-use stack structure and a method of manufacturing an electrode-use stack structure, the electrode-use stack structure including:
a substrate having conductivity; and
an electrode film provided on one main surface from among two main surfaces of the substrate and constituted from diamond crystals containing boron,
wherein an interface layer containing carbon as a main component and containing boron is provided between the substrate and the electrode film, and
the interface layer has a boron concentration higher than a boron concentration in the electrode film.

### ADVANTAGE OF DISCLOSURE

According to the present disclosure, an electrode-use stack structure having a low series resistance between a substrate and an electrode film constituted from diamond crystals containing boron can be provided.

### BRIEF DESCRIPTION OF DRAWINGS

FIG. 1 is a schematic cross-sectional view of an electrode-use stack structure according to an embodiment of the present disclosure.
FIG. 2 is a schematic perspective view of an electrochemical sensor according to an embodiment of the present disclosure.
FIG. 3 is a cross-sectional view of the electrochemical sensor illustrated in FIG. 2 taken along line A-A.
FIG. 4 is a schematic view of a vapor phase growth apparatus used when growing a diamond crystal.
FIG. 5(a) is a cross-sectional view illustrating a state in which concave grooves have been provided in the back surface of the stack structure illustrated in FIG. 1, and FIG. 5(b) is a schematic view illustrating a state in which a substrate of the stack structure is broken along a concave groove to obtain an electrode chip.
FIG. 6(a) illustrates a schematic cross-sectional view of Sample 1, FIG. 6(b) illustrates a schematic cross-sectional view of Sample 2, FIG. 6(c) illustrates a schematic cross-sectional view of Sample 3, and FIG. 6(d) illustrates a schematic cross-sectional view of Sample 4.
FIG. 7 is a graph showing evaluation results of series resistance and adhesion strength of Samples 1 to 4.
FIG. 8 is a graph showing evaluation results of a correlation between boron concentration in the interface layer and series resistance and a correlation between boron concentration in the interface layer and adhesion strength.
FIG. 9 is a graph showing evaluation results of a correlation between the silicon crystal grain density in the oxide layer and series resistance, and a correlation between the silicon crystal grain density in the oxide layer and adhesion strength.
FIG. 10 is a graph showing evaluation results of a correlation between the thickness of a SiB layer and series resistance and a correlation between the thickness of the SiB layer and adhesion strength.

### DETAILED DESCRIPTION

### <Embodiments of Present Disclosure>

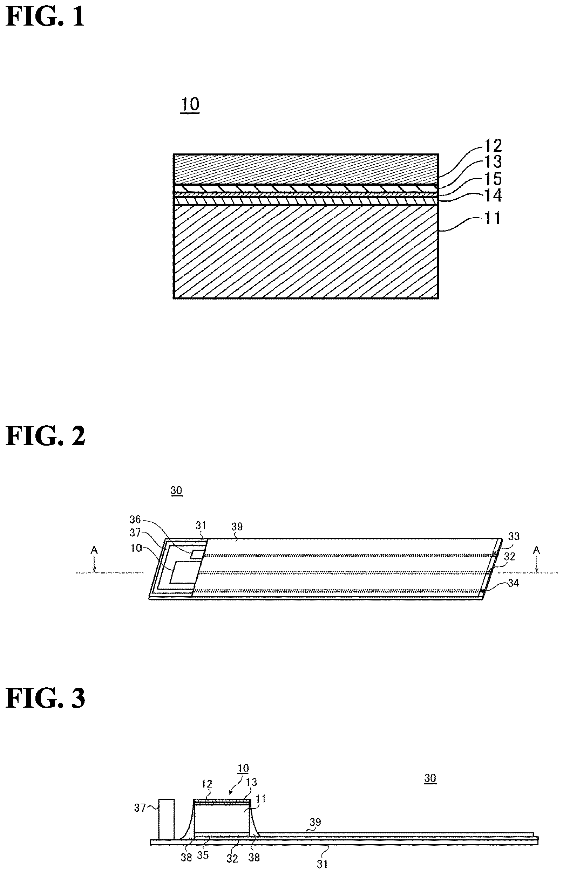

Hereinafter, an embodiment of the present disclosure will be described with reference to FIGS. 1 to 5.

### (1) Constitution of Electrode-Use Stack Structure

As illustrated in FIG. 1, an electrode-use stack structure 10 (hereinafter also referred to as a "stack 10") according to this embodiment includes a substrate 11 and an electrode film 12 provided on the substrate 11.

The stack 10 is shaped in a predetermined shape (for example, in a chip shape). The stack 10 is a vertical electrode (electrode chip) that extracts, from the substrate 11 side, a current caused by an electrochemical reaction generated on the surface of the electrode film 12. Such a stack 10 may be suitably used as a working electrode of a sensor 30 described later. An intermediate product (a later-described stacked substrate 10a before being shaped into a chip shape) obtained when the stack 10 is manufactured may be considered as the stack 10.

As the substrate 11, a substrate constituted from a low-resistance material, for example, a substrate having p-type conductivity is used. As the substrate 11, a substrate constituted from silicon (Si) as a main element and containing a p-type dopant such as boron (B) at a predetermined concentration, for example, a p-type single crystal Si substrate can be used. A p-type polycrystalline Si substrate can also be used as the substrate 11. The B concentration in the substrate 11 can be, for example, 5 × 10¹⁸ cm⁻³ or more and 1.5 × 10²⁰ cm⁻³ or less, preferably 5 × 10¹⁸ cm⁻³ or more and 1.2 × 10²⁰ cm⁻³ or less. When the B concentration in the substrate 11 is within the above range, the specific resistance of the substrate 11 can be reduced while avoiding a decrease in the manufacturing yield and performance degradation of the substrate 11.

The thickness of the substrate 11 can be, for example, 350 µm or more. As such, a commercially available single crystal Si substrate having a diameter of 6 inches or 8 inches can be used as-is as the substrate 11 without the need for back lapping to adjust the thickness. As a result, the productivity of the stack 10 can be increased, and the manufacturing cost therefor can be reduced. The upper limit of the thickness of the substrate 11 is not particularly limited. Meanwhile, the thickness of Si substrates that are generally available in the market currently is about 775 µm for a single crystal Si substrate having a diameter of 12 inches. Accordingly, the upper limit of the thickness of the substrate 11 in the current state of the art may be, for example, about 775 µm.

The electrode film 12 is provided on one of two main surfaces of the substrate 11. In the present specification, the main surface of the substrate 11 on which the electrode film 12 is provided may also be referred to as an "upper surface of the substrate 11". The electrode film 12 is provided over the entire upper surface of the substrate 11. The electrode film 12 causes a predetermined electrochemical reaction (for example, an electrochemical reaction of uric acid in urine) on a surface (exposed surface).

The electrode film 12 is a polycrystalline film constituted from diamond crystals containing a B element as a dopant, that is, diamond crystals having p-type conductivity. The diamond crystal is a crystal in which carbon (C) atoms are arranged in a pattern called a diamond crystal structure. The B concentration in the electrode film 12 can be, for example, 0.1 atomic % or more and 5 atomic % or less according to an analysis by TEM-EELS. TEM-EELS is an analysis in which Transmission Electron Microscopy (TEM) is combined with Electron Energy-Loss Spectroscopy (EELS).

The electrode film 12 can be grown (deposited or synthesized) by Chemical Vapor Deposition (CVD) method, Physical Vapor Deposition (PVD) method, or the like. Examples of the CVD method include a hot filament CVD method using a tungsten filament and a plasma CVD method, and examples of the PVD method include an ion beam method and an ionization evaporation method. The thickness of the electrode film 12 can be, for example, 0.5 µm or more and 10 µm or less, preferably 2 µm or more and 4 µm or less.

The electrode film 12 mainly has σ bonds and has π bonds in a part thereof, and a π bond density in the electrode film 12 gradually decreases from the substrate 11 side toward the growth direction (stacking direction). That is, a σ bond density in the electrode film 12 gradually increases from the substrate 11 side toward the growth direction.

An interface layer 13 containing C as a main component and containing B and Si derived from the substrate 11 (Si substrate) is provided between the substrate 11 and the electrode film 12.

Now, an example of an analysis method for an interface (interface layer 13) between the substrate 11 and the electrode film 12 will be described. First, a sample including an interface between the substrate 11 and the electrode film 12 in a longitudinal cross section of the stack 10 including the substrate 11 and the electrode film 12 is prepared. Then, the sample is embedded in epoxy resin and cut into a size suitable for cross-section polishing using a diamond low-speed cutter. The cut sample (analysis sample) is subjected to mechanical polishing using a water-resistant polishing sheet, buffed with a 0.25 µm-diameter diamond paste using polishing oil, and then polished with argon ions (cross-section polishing method, acceleration voltage: 10 kV) for 60 minutes. Thus, the observation surface of the analysis sample is made flat. At this stage, observation with Scanning Electron Microscope (SEM) may be performed in order to confirm the state of the interface and specify the TEM observation region. In addition, a TEM observation sample is produced from the analysis sample having undergone a predetermined polishing, etc., using Focused Ion Beam (FIB) processing observation apparatus. The TEM observation sample is a sample in the form of a thin film section. The TEM observation sample is subjected to FIB reprocessing as appropriate to bring the TEM observation sample into an optimal observation state. The TEM observation sample is mounted on a dedicated mesh and subjected to TEM observation and TEM-EELS analysis to analyze the interface (interface layer 13) between the substrate 11 and the electrode film 12. Note that the acceleration voltage when performing the TEM observation and TEM-EELS analysis is set to 200 kV, for example.

The interface layer 13 has a B concentration higher than the B concentration in the electrode film 12. Therefore, the interface layer 13 has a higher conductivity than the electrode film 12. In this way, by providing the interface layer 13 having a high B concentration, the series resistance between the substrate 11 and the electrode film 12 can be reduced.

Here, the "series resistance between the substrate 11 and the electrode film 12" includes resistance (hereinafter, also referred to as bulk resistance) of the substrate 11 and each layer (film) (hereinafter, collectively referred to as "each constituent member of the stack 10"), per se, that constitute the stack 10, and resistance (hereinafter, also referred to as inter-member resistance) generated at an interface between each of the constituent members of the stack 10. For example, when the stack 10 is configured as a stack of the substrate 11, the interface layer 13, and the electrode film 12, the magnitude of the "series resistance between the substrate 11 and the electrode film 12" is the total value of the bulk resistance of the substrate 11, the inter-member resistance between the substrate 11 and the interface layer 13, the bulk resistance of the interface layer 13, the inter-member resistance between the interface layer 13 and the electrode film 12, and the bulk resistance of the electrode film 12. Note that, since the bulk resistance of each of the constituent members of the stack 10 is sufficiently smaller than the inter-member resistance therebetween, the bulk resistance can be regarded as ignorable. Therefore, the magnitude of the "series resistance between the substrate 11 and the electrode film 12" in the present specification can also be regarded as being substantially equal to the total value of the inter-member resistances between each of the constituent members of the stack 10. That is, when the stack 10 is configured as a stack of the substrate 11, the interface layer 13, and the electrode film 12, it can be regarded that the magnitude of the series resistance between the substrate 11 and the electrode film 12 is substantially equal to the total value of the inter-member resistance between the substrate 11 and the interface layer 13 and the inter-member resistance between the interface layer 13 and the electrode film 12. In the present specification, the "series resistance between the substrate 11 and the electrode film 12" may also be simply referred to as "series resistance". Further, in the present specification, the concept of "reducing the series resistance between the substrate 11 and the electrode film 12" means to make the total value of the inter-member resistances lower than the resistance value between the substrate 11 and the electrode film 12 in the case where the interface layer 13 is not provided. Even when the stack 10 has the oxide layer 14 described later, since at least one of the capacitive coupling effect and the tunneling effect can be generated as described later, the series resistance can be made lower than the resistance value between the substrate 11 and the electrode film 12 in the case where the interface layer 13 is not provided.

Preferably, the B concentration in the interface layer 13 is twice or more the B concentration in the electrode film 12. Thus, an effect of series resistance reduction can be remarkably obtained (series resistance can be sufficiently reduced). More preferably, the B concentration in the interface layer 13 is five times or more the B concentration in the electrode film 12. Thus, the effect of series resistance reduction can be more remarkably obtained. Moreover, preferably, the B concentration in the interface layer 13 is 100 times or less the B concentration in the electrode film 12. This is because when the B concentration in the interface layer 13 exceeds 100 times the B concentration in the electrode film 12, the effect of series resistance reduction is saturated, while the interface layer 13 is embrittled, and the adhesion between the substrate 11 and the electrode film 12 may decrease in some cases.

The B concentration in the interface layer 13 can be, for example, 0.2 atomic % or more and 10 atomic % or less, and preferably 0.5 atomic % or more and 10 atomic % or less, according to an analysis by TEM-EELS.

Preferably, the interface layer 13 has a π bond. Thus, an effect of relaxing the stress between the substrate 11 and the electrode film 12, and an effect of reducing warpage of the electrode film 12, as well as an effect of reducing warpage of the stack 10 can be obtained. Preferably, the π bond density in the interface layer 13 is higher than the π bond density in the electrode film 12.

In the process of providing the interface layer 13, a π bond is generated in the interface layer 13. The π bond in the interface layer 13 has a characteristic of being more easily cleaved than the σ bond in the growth process of the diamond crystal including the process of providing the interface layer 13. When the π bond is cleaved in the growth process of the diamond crystal, a dangling bond is generated, and B contained in a B-containing gas described later is bonded to the dangling bond, thereby providing C-B bonds. When a large amount of this reaction occurs, the interface layer 13 becomes a layer having a high B concentration. Thus, part of the π bond generated in the process of providing the interface layer 13 is cleaved in the growth process of the diamond crystal to contribute to the incorporation of B, and another part remains as the π bond without contributing to the incorporation of B.

By generating, in the process of providing the interface layer 13, a large amount of π bonds in the interface layer 13 so that the interface layer 13 has π bonds in the state of the stack 10 (π bonds remain in the interface layer 13 after the growth of the diamond crystal is completed), a large amount of the above mentioned reaction can be generated, and as a result, the incorporation ofB into the interface layer 13 can be reliably performed. When the interface layer 13 has the π bonds in this way, B can be reliably incorporated into the interface layer 13. As such, the B concentration in the interface layer 13 can be increased easily and reliably. As a result, the above mentioned series resistance can be reliably reduced.

In addition, by generating, in the process of providing the interface layer 13, a large amount of π bonds in the interface layer 13 so that the π bond density in the interface layer 13 (the π bond density remaining in the interface layer 13) is higher than the π bond density in the electrode film 12, B can be more reliably incorporated into the interface layer 13. As such, the B concentration in the interface layer 13 can be reliably made higher than the B concentration in the electrode film 12.

The interface layer 13 is provided over the entire upper surface of the substrate 11 so that the base is not exposed. That is, the interface layer 13 can be a continuous layer that covers the entire upper surface of the substrate 11 in a plan view (when the interface layer 13 is viewed from above in the vertical direction with respect to the upper surface of the substrate 11). In this way, the above mentioned effect of series resistance reduction can be more reliably obtained.

The thickness of the interface layer 13 can be, for example, 1 nm or more. As a result, the above mentioned effect of series resistance reduction can be sufficiently and reliably obtained. When the thickness of the interface layer 13 is less than 1 nm, the above mentioned effect of series resistance reduction may not be obtained sufficiently in some cases.

The upper limit of the thickness of the interface layer 13 is not particularly limited. However, when the interface layer 13 is too thick, the effect of series resistance reduction is saturated, while productivity may decrease, manufacturing cost may increase, or adhesion reliability may decrease in some cases. Thus, preferably, the thickness of the interface layer 13 is, for example, 200 nm or less.

Preferably, an oxide layer 14 containing a main element (Si) constituting the substrate 11 and oxygen (O) is provided (interposed) between the substrate 11 and the interface layer 13. For example, when the substrate 11 is constituted from Si (when the substrate 11 is a Si substrate), it is preferred that an amorphous oxide layer 14 containing Si and O is provided. An amorphous oxide layer 14 containing Si and O is a layer constituted from an amorphous silicon-based oxide. The oxide layer 14 can be constituted by modifying the uppermost surface (surface layer) of the substrate 11. In this case, the oxide layer 14 can be regarded as part of the substrate 11. By providing the oxide layer 14, adhesion between the substrate 11 and the interface layer 13, and in turn, adhesion between the substrate 11 and the electrode film 12, can be improved.

The oxide layer 14 is a layer having low conductivity (a layer having insulating properties). Therefore, there is a concern that the series resistance may increase by providing the oxide layer 14.

By providing the interface layer 13 having a high B concentration (high conductivity), and sandwiching the oxide layer 14 between the substrate 11 having conductivity and the interface layer 13 having conductivity as in this embodiment, at least one of a capacitive coupling effect and a tunneling effect can be generated between the substrate 11 and the interface layer 13, and a current caused by an electrochemical reaction generated on the surface of the electrode film 12 can be made to flow to the substrate 11 side. By providing the interface layer 13 in this way, the above mentioned concern can be resolved, and an increase in series resistance due to the interposition of the oxide layer 14 can be avoided.

The oxide layer 14 may be a continuous layer or a discontinuous layer. The oxide layer 14 being a discontinuous layer is more preferable than it being a continuous layer, because if so, the upper surface of the substrate 11 and the interface layer 13 can be partially brought into contact with each other. That is, when the oxide layer 14 is a discontinuous layer, the above mentioned effect of series resistance reduction can be more readily obtained than when the oxide layer 14 is a continuous layer, and an increase in series resistance due to the interposition of the oxide layer 14 can be reliably avoided, which is preferable. In addition, when the oxide layer 14 is a discontinuous layer, the time required to provide the oxide layer 14 can be shortened compared to when the oxide layer 14 is a continuous layer, and production cost can also be reduced.

The thickness of the oxide layer 14 can be, for example, 10 nm or more and 100 nm or less.

When the thickness of the oxide layer 14 is less than 10 nm, it is difficult to obtain the effect of improving the adhesion between the substrate 11 and the electrode film 12. When the thickness of the oxide layer 14 is 10 nm or more, the above mentioned effect of improving adhesion can be remarkably obtained. When the thickness of the oxide layer 14 exceeds 100 nm, the capacitive coupling effect and the tunneling effect occur less readily, and an increase in series resistance due to the interposition of the oxide layer 14 may not be avoided in some cases. When the thickness of the oxide layer 14 is 100 nm or less, at least one of the capacitive coupling effect and the tunneling effect, or preferably both of the capacitive coupling effect and the tunneling effect, can be reliably generated, and the above mentioned concern can be resolved.

When the substrate 11 is constituted from Si, the oxide layer 14 preferably contains crystal grains of Si (hereinafter also referred to as "Si crystal grains"). These Si crystal grains are conductive crystal grains derived from the substrate 11 (Si substrate), and are dispersed in the matrix phase of the oxide layer 14. When the Si crystal grains are dispersed in the matrix phase of the oxide layer 14 in this way, an increase in series resistance due to the interposition of the oxide layer 14 can be reliably avoided.

The Si crystal grain density in the oxide layer 14 can be, for example, 10 grains/µm³ or more and 500 grains/µm³ or less.

When the Si crystal grain density is less than 10 grains/µm³, it is more difficult to obtain the effect of avoiding an increase in series resistance. When the Si crystal grain density is 10 grains/µm³ or more, the effect of avoiding an increase in series resistance can be remarkably obtained. When the Si crystal grain density exceeds 500 grains/µm³, the oxide layer 14 may be embrittled, and the adhesion between the substrate 11 and the electrode film 12 may decrease in some cases. When the Si crystal grain density is 500 grains/µm³ or less, embrittlement of the oxide layer 14 can be avoided.

The size (average crystal grain size) of the Si crystal grains can be, for example, 1 nm or more and 50 nm or less.

When the size of the Si crystal grains is less than 1 nm, it is difficult to obtain the effect of avoiding an increase in series resistance. When the size of the Si crystal grains is 1 nm or more, the effect of avoiding an increase in series resistance can be remarkably obtained. When the size of the Si crystal grains exceeds 50 nm, the oxide layer 14 may be embrittled, and the adhesion between the substrate 11 and the electrode film 12 may decrease in some cases. When the size of the Si crystal grains is 50 nm or less, embrittlement of the oxide layer 14 can be avoided.

Preferably, a layer 15 (hereinafter, also referred to as a "SiB layer 15") containing the main element (Si) constituting the substrate 11 and B, and containing no O is provided on a surface of the oxide layer 14 (hereinafter, also referred to as an "upper surface of the oxide layer 14") in contact with the interface layer 13. That is, preferably, such a SiB layer 15 is provided between the interface layer 13 and the oxide layer 14. The SiB layer 15 can be provided by modifying the upper surface (surface layer) of the oxide layer 14. The SiB layer 15 can also be regarded as a part of the interface layer 13.

The SiB layer 15 has a higher conductivity than the interface layer 13. Accordingly, by providing the SiB layer 15 and sandwiching the oxide layer 14 between the substrate 11 having conductivity and the SiB layer 15 having high conductivity, at least one of the above mentioned capacitive coupling effect and tunneling effect can be reliably generated between the substrate 11 and the SiB layer 15, and a current caused by an electrochemical reaction generated on the surface of the electrode film 12 can be reliably made to flow to the substrate 11 side. As a result, an increase in series resistance due to the interposition of the oxide layer 14 can be reliably avoided.

The thickness of the SiB layer 15 can be, for example, 1 nm or more and 100 nm or less.

When the thickness of the SiB layer 15 is less than 1 nm, the above mentioned capacitive coupling effect or tunneling effect occurs less readily. When the thickness of the SiB layer 15 is 1 nm or more, at least one of the above mentioned capacitive coupling effect and tunneling effect can be reliably generated, and an increase in series resistance due to the interposition of the oxide layer 14 can be reliably avoided. When the thickness of the SiB layer 15 exceeds 100 nm, the adhesion between the substrate 11 and the electrode film 12 may decrease in some cases. When the thickness of the SiB layer 15 is 100 nm or less, a decrease in the adhesion between the substrate 11 and the SiB layer 15, and thus a decrease in the adhesion between the substrate 11 and the electrode film 12, can be avoided.

The stack 10 has a rectangular outer shape, for example, a square outer shape when the stack 10 is viewed from above in the vertical direction with respect to the upper surface of the substrate 11. The plane area of the stack 10 can be , for example, 1 mm² or more and 25 mm² or less. The plane area of the stack 10 is the area of the stack 10 when the stack 10 is viewed from above in the vertical direction with respect to the upper surface of the substrate 11. When the plane area of the stack 10 is 1 mm² or more, the stack 10 can be accurately and stably shaped with ease by a method involving breaking, described later. In addition, a decrease in handling property and a decrease in mounting stability of the stack 10 can also be suppressed. When the plane area of the stack 10 is 25 mm² or less, an increase in the size of the sensor 30 using the stack 10, described later, can be avoided; that is, a smaller sensor 30 can be obtained.

### (2) Constitution of Electrochemical Sensor

An electrochemical sensor having the above mentioned stack 10 (electrode chip) will be described. In this embodiment, an electrochemical sensor that measures the concentration of a detection target (e.g., uric acid) in a test liquid (e.g., human urine) by a three-electrode method will be described as an example.

As illustrated in FIGS. 2 and 3, the electrochemical sensor 30 (also referred to as a "sensor 30") according to the present embodiment includes the stack 10 (electrode chip). In FIG. 3, the oxide layer 14 and the SiB layer 15 are omitted for the sake of clarity.

The sensor 30 includes a base material 31 that supports the above mentioned stack 10 and the like. The base material 31 is configured as a sheet-like (plate-like) member. The base material 31 can be constituted from an insulating material, such as a composite resin, ceramic, glass, plastic, combustible material, biodegradable material, nonwoven fabric, paper, etc., having insulating properties. Preferably, the base material 31 is constituted from, for example, a glass epoxy resin or polyethylene terephthalate (PET). The base material 31 may alternatively be a semiconductor substrate or a metal substrate configured such that a surface on which the stack 10 and so on are to be provided has insulating properties. The planar shape of the base material 31 can be, for example, a rectangular shape. The base material 31 has a predetermined physical strength and mechanical strength, for example, a strength such that the material 31 does not bend or break within a certain period of time after urine has adhered.

Three wires (electrical wires) 32, 33, and 34 are disposed on one of the two main surfaces of the base material 31 (hereinafter also referred to as an "upper surface of the base material 31") so as to be spaced apart from each other, from one end toward the other end in the longitudinal direction of the base material 31. Examples of the material for the wires 32 to 34 include various precious metals such as copper (Cu), gold (Au), platinum (Pt), silver (Ag), and palladium (Pd), various metals such as aluminum (Al), iron (Fe), nickel (Ni), chromium (Cr), and titanium (Ti), alloys mainly containing such precious metals or metals, oxides of the precious metals or alloys, metal oxides, and carbon. The wires 32 to 34 may be constituted from the same material or from dissimilar materials. The wires 32 to 34 can be constituted using a subtractive method, a semi-additive method, or the like. Alternatively, the wires 32 to 34 can also be constituted using a printing method such as screen printing, gravure printing, offset printing, or inkjet printing, an evaporation method, or the like.

The stack 10 as a working electrode is electrically connected to one end of the wire 32 via a conductive bonding member 35 (see FIG. 3). The stack 10 is fixed on the base material 31 via the conductive bonding member 35 so that the electrode film 12 comes on the upper side (that is, the substrate 11 faces the base material 31). As the conductive bonding member 35, a conductive paste (conductive adhesive), a conductive tape, or the like can be used. The periphery of the stack 10 is covered with an insulating resin 38 (see FIG. 3). The insulating resin 38 is provided so that at least part of the upper surface of the electrode film 12 is exposed and the substrate 11 is not exposed.

A reference electrode 36 is connected to one end of the wire 33. The reference electrode 36 is an electrode serving as a reference when the potential of the stack 10 (working electrode) is determined. The reference electrode 36 can be, for example, a silver/silver chloride (Ag/AgCl) electrode. Alternatively, the reference electrode 36 can also be a standard hydrogen electrode, a reversible hydrogen electrode, a palladium-hydrogen electrode, a saturated calomel electrode, a carbon electrode, or the like. The reference electrode 36 can be electrically connected to the wire 33 via a conductive bonding member such as a conductive paste. The reference electrode 36 can also be an electrode constituted from a metal such as Pt, Au, Cu, Pd, Ni, or Ag, and in this case, the reference electrode 36 can be integrally constituted with the wire 33 by a known method such as dispensing or screen printing.

A counter electrode 37 is connected to one end of the wire 34. The counter electrode 37 is provided so as to surround the stack 10 and the reference electrode 36. The counter electrode 37 can be an electrode constituted from a metal such as Pt, Au, Cu, Pd, Ni, or Ag, a carbon electrode, or the like. The counter electrode 37 is constituted integrally with the wire 34 by a subtractive method, a semi-additive method, or the like. The counter electrode 37 may alternatively be constituted separately from the wire 34, and may be connected to the wire 34 via a conductive bonding member such as a conductive paste.

The wires 32 to 34 are covered with a waterproof member 39 such as a resin having insulating properties so that when urine is supplied to the sensor 30, the urine does not come into contact with the wires 32 to 34.

When urine is supplied to the sensor 30 and a predetermined voltage is applied to the electrode group including the stack 10, the reference electrode 36, and the counter electrode 37 in a state where the urine is in contact with the electrode group, an oxidation-reduction reaction of the uric acid occurs on the surface of the electrode film 12.

### (3) Method of Producing Electrode-Use Stack Structure and Electrochemical Sensor

Next, a method of producing the above mentioned stack 10 and the sensor 30 will be described.

The production sequence of the stack 10 according to the present embodiment involves:
preparing the substrate 11 <Step A>;
providing an interface layer 13 on the substrate 11, the interface layer 13 containing C as a main component and containing B <Step B>; and
providing an electrode film 12 on the interface layer 13, the electrode film 12 containing B and diamond crystals <Step C>,
and the B concentration in the interface layer 13 is set to be higher than the B concentration in the electrode film 12.

Step A includes placing the substrate 11 into a growth chamber, the growth chamber being capable of receiving supply of a B-containing gas having a first pyrolysis temperature and a C-containing gas having a second pyrolysis temperature higher than the first pyrolysis temperature.

Step B includes providing the interface layer 13 on the substrate 11 by supplying the B-containing gas and the C-containing gas into the growth chamber under a predetermined temperature condition higher than the first pyrolysis temperature and lower than the second pyrolysis temperature.

Step C includes providing the electrode film 12 on the interface layer 13 by supplying the B-containing gas and the C-containing gas into the growth chamber under a predetermined temperature condition equal to or higher than the second pyrolysis temperature (preferably higher than the second pyrolysis temperature).

The production sequence of the stack 10 further involves providing, on the substrate 11, an oxide layer 14 containing Si and O <Step D>, Step D being carried out after Step A and before Step B.

The production sequence of the stack 10 further involves providing, on an outermost surface of the oxide layer 14, a SiB layer 15 containing Si and B and not containing O <Step E>, Step E being carried out after Step D and before Step B.

### <Step A>

First, as the substrate 11, a conductive substrate, for example, a Si substrate having a circular outer shape in a plan view is prepared. Of the two main surfaces of the substrate 11, the surface (that is, a surface serving as an upper surface of the substrate 11, also referred to as a "crystal growth surface") on which diamond crystals are to be grown (deposited) is subjected in the air to scratching treatment of increasing the density of nucleation of diamond. The scratching treatment is a treatment of scratching the crystal growth surface using, e.g., diamond abrasive grains (diamond powder) of about several µm (a treatment of applying processing damage to the crystal growth surface).

In the scratching treatment, it is preferable to provide fine scratches on the crystal growth surface of the substrate 11 unevenly in the plane (so that processing damage is introduced sparsely in some parts and densely in other parts in the plane). When the scratches are introduced unevenly (sparsely/densely) in the plane like this, uneven strain is generated in the oxide layer 14 provided in Step D, and Si crystal grains can be incorporated (maintained) in the oxide layer 14, due to relaxation of the strain.

The scratching treatment may be performed so as to partially crush the crystal growth surface of the substrate 11, thereby producing a powder of Si crystals having a predetermined grain size. Alternatively, the scratching treatment may be performed so as to rub the crystal growth surface of the substrate 11 using a diamond powder having a predetermined average particle diameter, thereby producing a powder of Si crystals having a predetermined grain size. Such treatments also allow Si crystal grains to be incorporated in the oxide layer 14 provided in Step D.

### <Diamond Crystal Growth>

After the scratching treatment is completed, Steps D, E, B, and C described later are performed by, for example, a hot filament CVD method using a tungsten filament to grow diamond crystals on the crystal growth surface of the substrate 11.

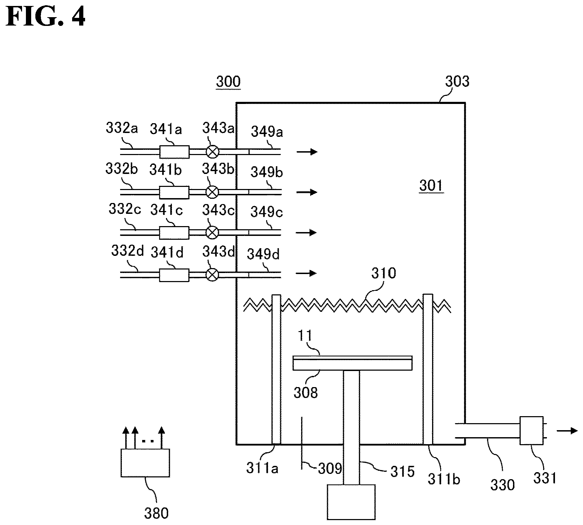

Diamond crystals can be grown using, for example, a hot filament CVD apparatus 300 such as that illustrated in FIG. 4. The hot filament CVD apparatus 300 includes an airtight container 303 constituted from a heat-resistant material such as quartz and having a growth chamber 301 inside. A susceptor 308 that holds the substrate 11 is provided in the growth chamber 301.

Gas supply pipes 332a to 332d are connected to a side wall of the airtight container 303. The gas supply pipes 332a to 332d are respectively provided with flow rate controllers 341a to 341d and valves 343a to 343d in order from the upstream side of the gas flow. Nozzles 349a to 349d that supply the gases supplied from the gas supply pipes 332a to 332d into the growth chamber 301 are connected to downstream ends of the gas supply pipes 332a to 332d, respectively.

Nitrogen (N₂) gas is supplied from the gas supply pipe 332a into the growth chamber 301 via the nozzle 349a. Hydrogen (H₂) gas is supplied from the gas supply pipe 332b into the growth chamber 301 via the nozzle 349b. A B-containing gas having a first pyrolysis temperature is supplied from the gas supply pipe 332c into the growth chamber 301 via the nozzle 349c. Examples of the B-containing gas include trimethyl boron (B(CH₃)₃, abbreviation: TMB) gas and diborane (B₂H₆) gas. A C-containing gas having a second pyrolysis temperature higher than the first pyrolysis temperature is supplied from the gas supply pipe 332d into the growth chamber 301 via the nozzle 349d. Examples of the C-containing gas include methane (CH₄) gas and ethane (C₂H₆) gas.

Another side wall of the airtight container 303 is provided with an exhaust pipe 330 that exhausts the inside of the growth chamber 301. A pump 331 is provided on the exhaust pipe 330. A temperature sensor 309 that measures the temperature in the growth chamber 301 is provided in the airtight container 303. In addition, a tungsten filament 310 and a pair of electrodes (for example, molybdenum (Mo) electrodes) 311a and 311b that hold the tungsten filament 310 and are connected to a power source (not illustrated) are provided in the airtight container 303. Each member included in the hot filament CVD apparatus 300 is connected to a controller 380 configured as a computer, and a processing procedure and processing conditions described later are controlled by a program executed on the controller 380.

### (Placement of Substrate)

First, the substrate 11 is placed (loaded) in the growth chamber 301 (airtight container 303) configured to be capable of receiving supply of the B-containing gas and the C-containing gas, and is held on the susceptor 308.

### (Step D)

Subsequently, the oxide layer 14 containing Si and O is provided on the substrate 11. Specifically, a current is made to flow between the electrodes 311a and 311b to start heating the tungsten filament 310. As the tungsten filament 310 is heated, the substrate 11 held on the susceptor 308 is also heated. At this time, the temperature of the tungsten filament 310 is controlled so that the temperature of the substrate 11 gradually rises at a predetermined rate from room temperature (27 °C) to a predetermined temperature (diamond crystal growth temperature in Step C described later). For example, the temperature of the tungsten filament 310 is controlled to increase at a rate of 10 °C/min or more and 20 °C/min or less, preferably 13 °C/min or more and 17 °C/min or less. The temperature of the tungsten filament 310 is raised to a predetermined temperature at which Step C is started, and heating of the tungsten filament 310, that is, heating of the substrate 11, is continued until Step C is completed.

At the start of heating of the substrate 11, the inside of the growth chamber 301 is in an O-containing atmosphere. In addition, processing damage (mechanical damage) has been introduced in the crystal growth surface of the substrate 11 by the scratching treatment. In the process of gradually heating the substrate 11 from room temperature in an O-containing atmosphere, (the surface layer of) the crystal growth surface of the substrate 11 is amorphized, and is modified into the amorphous oxide layer 14. That is, the amorphous oxide layer 14 containing Si and O is provided on the crystal growth surface (upper surface) of the substrate 11.

In addition, by performing the above mentioned scratching treatment, the oxide layer 14 including Si crystal grains dispersed in the matrix phase thereof can be obtained.

In addition, the provision of the oxide layer 14 (amorphization of the upper surface of the substrate 11) may, in some cases, continuously proceed even after the start of Step E described later (even during the execution of Steps E, B, and C).

### (Step E)

Subsequently, the SiB layer 15 is provided on the outermost surface of the oxide layer 14. Specifically, after the lapse of a predetermined time from the start of heating of the substrate 11 (after performing Step D), at a timing before the temperature of the substrate 11 reaches the first pyrolysis temperature (the pyrolysis temperature of the B-containing gas), exhausting of the inside of the growth chamber 301 and supply of the H₂ gas, the B-containing gas (e.g., TMB gas), and the C-containing gas (e.g., CH₄ gas) into the growth chamber 301 are started. The supply amount (supply ratio) of each gas at this time can be equivalent to the supply amount in Step C described later. At this time, N₂ gas may also be supplied into the growth chamber 301 if necessary. Note that the exhausting of the inside of the growth chamber 301 and the supply of the gas into the growth chamber 301 are continued until completion of Step C.

As mentioned above, the temperature of the substrate 11 gradually rises at a predetermined rate. When the temperature of the substrate 11 approaches the first pyrolysis temperature, decomposition (thermal decomposition) of the B-containing gas starts gradually, and when the temperature of the substrate 11 becomes equal to or higher than the first pyrolysis temperature, a substantial degree of decomposition of the B-containing gas starts. A predetermined active species is generated due to the decomposition of the B-containing gas, and this active species is supplied onto the substrate 11 (on the oxide layer 14); as a result, the outermost surface (surface layer) of the oxide layer 14 is modified into the SiB layer 15. That is, the SiB layer 15 is provided on the outermost surface of the oxide layer 14.

The temperature condition in this step is a condition such that only the B-containing gas is decomposed and the C-containing gas is not decomposed (not thermally decomposed).

### (Step B)

Subsequently, the interface layer 13 is provided on the SiB layer 15. Specifically, the temperature of the substrate 11 is further raised at a predetermined rate in a state where the exhausting of the inside of the growth chamber 301 and the supply of the gas into the growth chamber 301 are continued. When the temperature of the substrate 11 approaches the second pyrolysis temperature (the pyrolysis temperature of the C-containing gas) (that is, when the temperature is lower than the second pyrolysis temperature but close to the second pyrolysis temperature), the decomposition of the C-containing gas gradually starts in addition to the decomposition of the B-containing gas. A predetermined active species is generated due to the decomposition of the C-containing gas. The active species generated due to the decomposition of the B-containing gas and the C-containing gas are supplied onto the substrate 11; as a result, the interface layer 13 containing C as a main component and containing B is provided on the SiB layer 15.

The temperature condition in this step, that is, a predetermined temperature condition (first temperature condition) higher than the first pyrolysis temperature and lower than the second pyrolysis temperature is a condition under which decomposition of the B-containing gas is more dominant than decomposition of the C-containing gas. The first temperature condition is a condition under which the oxide layer 14 is not crystallized but is amorphized.

### (Step C)

Subsequently, the electrode film 12 is provided on the interface layer 13. Specifically, the temperature of the substrate 11 is further raised at a predetermined rate in a state where the exhausting of the inside of the growth chamber 301 and the supply of the gas into the growth chamber 301 are continued. When the temperature of the substrate 11 becomes equal to or higher than the second pyrolysis temperature, a substantial degree of decomposition of the C-containing gas starts. As a result, diamond crystals containing B grow on the interface layer 13, and the electrode film 12 is provided.

In this step, when the temperature of the substrate 11 reaches a predetermined temperature (diamond crystal growth temperature) equal to or higher than the second pyrolysis temperature, the temperature of the tungsten filament 310 is controlled so that the temperature of the substrate 11 is maintained at the diamond crystal growth temperature.

The temperature condition in this step, that is, a predetermined temperature condition (second temperature condition) equal to or higher than the second pyrolysis temperature is a condition under which the oxide layer 14 is not crystallized but is amorphized.

The following are examples of the processing conditions for Step C.
Pressure in growth chamber: 5 Torr or more and 50 Torr or less (665 Pa or more and 6650 Pa or less), preferably 10 Torr or more and 35 Torr or less (1330 Pa or more and 4655 Pa or less)
Ratio of supply amount of B-containing gas to supply amount of C-containing gas (B-containing gas/C-containing gas): 0.003 % or more and 0.8 % or less
Growth Temperature: 600 °C or more and 1000 °C or less, preferably 650 °C or more and 800 °C or less
Filament Temperature: 1800 °C or more and 2500 °C or less, more preferably 2000 °C or more and 2200 °C or less
Growth Time: 200 minutes or more and 500 minutes or less, preferably 300 minutes or more and 500 minutes or less
Ratio of supply amount of C-containing gas to supply amount of H₂ gas (C-containing gas/H₂ gas): 2 % or more and 5 % or less

By performing Steps A, D, E, B, and C in order as mentioned above, a stacked substrate 10a in which the oxide layer 14, the SiB layer 15, the interface layer 13, and the electrode film 12 are sequentially stacked on the crystal growth surface of the substrate 11 can be obtained.

By setting the first temperature condition and the second temperature condition as mentioned above, the B concentration in the interface layer 13 can be made to be higher than the B concentration in the electrode film 12.

Further, by setting the first temperature condition as mentioned above, the interface layer 13 having π bonds can be obtained.

By setting the first temperature condition and the second temperature condition as mentioned above, the π bond density in the interface layer 13 can be made larger than the π bond density in the electrode film 12.

### (Substrate Removal)

After the diamond crystal growth (Step C) is completed, at least the supply of each gas into the growth chamber 301 and the heating of the tungsten filament 310 are stopped. Then, when the temperature in the growth chamber 301 has dropped to a predetermined temperature, the stacked substrate 10a is removed from the growth chamber 301 to the outside of the airtight container 303.

### <Shaping>

Then, the stacked substrate 10a is shaped into a predetermined shape (for example, a chip shape) to obtain the stack 10.

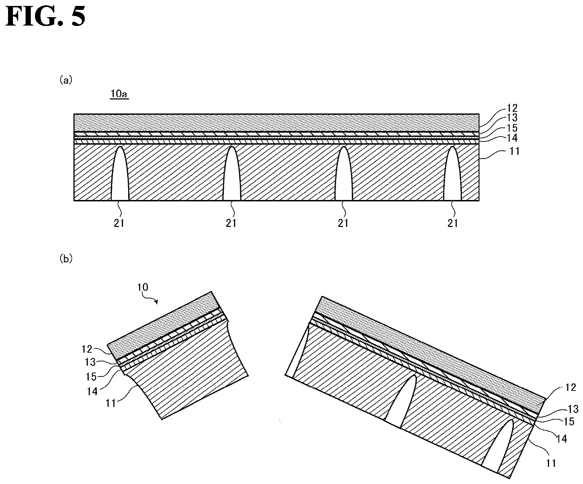

Specifically, as illustrated in FIG. 5(a), concave grooves 21 (for example, laser-processed grooves or scribe grooves) are provided from the back surface (substrate 11 side) of the stacked substrate 10a. The grooves 21 can be provided by using a known method such as a laser processing method such as laser scribing or laser dicing, a mechanical processing method, or etching. The grooves 21 are provided so as not to penetrate through the substrate 11 in the thickness direction, that is, so as not to reach the electrode film 12. For example, the grooves 21 are provided so that the thickness of the thinnest portion of the substrate 11 is 10 µm or more and 80 µm or less. Accordingly, alteration of the electrode film 12 can be suppressed, and as a result, in the sensor 30 having the stack 10, a decrease in the measurement accuracy of the concentration of uric acid (detection target), that is, a decrease in the sensitivity of the sensor 30, can be avoided. The "alteration of the electrode film 12" above means that the bonding between carbon atoms assumes the form of an sp³ bonding structure (diamond structure) on the outermost surface (uppermost surface) of the electrode film 12, and the bonding between carbon atoms assumes the form of an sp² bonding structure (graphite structure) on the substrate 11 side of the electrode film 12.

Subsequently, as illustrated in FIG. 5(b), the stacked substrate 10a is bent along a groove 21 in a direction in which the electrode film 12 is bent outward, and the substrate 11 becomes broken. Thus, the stack 10 (see FIG. 1) including at least the substrate 11, the interface layer 13, and the electrode film 12 can be obtained.

It is also conceivable to provide the grooves 21 from the front surface (the electrode film 12 side) of the stacked substrate 10a. However, since the electrode film 12 constituted from diamond crystals has high hardness, it is difficult to provide the grooves 21 from the electrode film 12 side by a laser processing method, a mechanical processing method, or the like.

Instead of the above mentioned method using breaking, it is also conceivable to produce the stack 10 by shaping the stacked substrate 10a into a predetermined shape by dry etching or the like. However, it is extremely difficult to shape the stacked substrate 10a having the high hardness electrode film 12 constituted from diamond crystals into a predetermined shape by dry etching or the like. In addition, an altered region may, in some cases, be generated in the electrode film 12 due to dry etching.

### <Production of Electrochemical Sensor>

After the stack 10 is produced, the sensor 30 is produced. Specifically, first, the base material 31 is prepared. Then, the wires 32 to 34 of a predetermined pattern, the reference electrode 36 electrically connected to the wire 33, and the counter electrode 37 electrically connected to the wire 34 are provided on the base material 31. Alternatively, a base material 31 in which the wires 32 to 34, the reference electrode 36, the counter electrode 37, and the like are provided in advance may be prepared. Further, the conductive bonding member 35 is provided on the base material 31 so as to be electrically connected to the wire 32, and the stack 10 is disposed on the conductive bonding member 35. At this time, the stack 10 is disposed so that the electrode film 12 comes on the upper side (that is, so that the substrate 11 faces the base material 31). Accordingly, the stack 10 is fixed on the base material 31 and is electrically connected to the wire 32 via the conductive bonding member 35. Then, the periphery of the stack 10 is surrounded by the insulating resin 38, and the wires 32 to 34 are covered with the waterproof member 39. Thus, the sensor 30 as illustrated in FIGS. 2 and 3 is obtained.

### (4) Effects

According to the present embodiments, one or more effects described below can be obtained.
(a) Since the interface layer 13 having the B concentration higher than the B concentration in the electrode film 12 is provided between the substrate 11 and the electrode film 12, the series resistance between the substrate 11 and the electrode film 12 can be reduced. Accordingly, it becomes easier to extract, from the substrate 11 side, the current caused by the electrochemical reaction generated on the surface of the electrode film 12. As a result, in the sensor 30 including the stack 10, the sensor sensitivity can be increased.
(b) Since the interface layer 13 has a π bond, the effect of relaxing the stress between the substrate 11 and the electrode film 12, the effect of reducing warpage of the electrode film 12, and the effect of reducing warpage of the stack 10 can be obtained.
(c) Since the interface layer 13 has a π bond, B can be reliably incorporated into the interface layer 13. Accordingly, the B concentration in the interface layer 13 can be increased easily and reliably. As a result, the above mentioned series resistance can be reliably reduced.
(d) Since the π bond density in the interface layer 13 is higher than the π bond density in the electrode film 12, the B concentration in the interface layer 13 can be reliably made higher than the B concentration in the electrode film 12.
(e) Since the oxide layer 14 is provided between the substrate 11 and the interface layer 13, the adhesion between the substrate 11 and the interface layer 13, and thus the adhesion between the substrate 11 and the electrode film 12, can be increased.
(f) Even when the oxide layer 14 is provided, by sandwiching the oxide layer 14 between the substrate 11 having conductivity and the interface layer 13 having conductivity, at least one of a capacitive coupling effect and a tunneling effect is generated between the substrate 11 and the interface layer 13, and a current caused by an electrochemical reaction generated on the surface of the electrode film 12 can be made to flow to the substrate 11 side. By providing the interface layer 13 in this way, an increase in series resistance due to the interposition of the oxide layer 14 can be avoided.
(g) Since the oxide layer 14 includes Si crystal grains, an increase in series resistance due to the interposition of the oxide layer 14 can be reliably avoided.
(h) By providing the SiB layer 15 having high conductivity on the surface of the oxide layer 14 in contact with the interface layer 13, that is, by sandwiching the oxide layer 14 between the substrate 11 and the SiB layer 15 having high conductivity, at least one of the capacitive coupling effect and the tunneling effect can be reliably generated between the substrate 11 and the SiB layer 15, and the current caused by the electrochemical reaction generated on the surface of the electrode film 12 can be reliably made to flow to the substrate 11 side. As a result, an increase in series resistance due to the interposition of the oxide layer 14 can be avoided.

### (5) Modified Example

The embodiments above can be modified as in the following modified examples. In the following description of the modified examples, the same components as those of the above mentioned embodiments are denoted by the same reference signs, and the description thereof will be omitted. Further, the above mentioned embodiments and the following modified examples can be arbitrarily combined.

### (Modified Example 1)

In the above mentioned embodiments, an example in which the substrate 11 is a Si substrate is described, but the present disclosure is not limited thereto.

The substrate 11 may be a substrate other than the Si substrate, provided that the substrate has conductivity. As the substrate 11 having conductivity, for example, a substrate constituted from a Si compound such as a silicon carbide substrate (SiC substrate), a niobium (Nb) substrate, or a metal substrate constituted from molybdenum (Mo), titanium (Ti), or the like can be used. In this modified example as well, since the interface layer 13 having the B concentration higher than the B concentration in the electrode film 12 is provided between the substrate 11 and the electrode film 12, an equivalent effect to the above mentioned embodiments can be obtained.

When the oxide layer 14 is provided during heating in the diamond crystal growth process in the case of the present modified example (i.e. the substrate 11 is a substrate other than a Si substrate), the oxide layer 14 becomes a layer containing a main element (Nb, Mo, Ti, etc.) constituting the substrate and O, but does not become an amorphous layer. Even with such an oxide layer 14, equivalent effects to those in the above mentioned embodiments, that is, the effect of improving adhesion between the substrate 11 and the interface layer 13, and thus the adhesion between the substrate 11 and the electrode film 12, can be obtained.

### (Modified Example 2)

In the above mentioned embodiments, an example in which the interface layer 13 is a continuous layer covering the entire upper surface of the substrate 11 is described, but the present disclosure is not limited thereto.

The interface layer 13 may be a layer partially covering the upper surface of the substrate 11. For example, the interface layer 13 may be a discontinuous layer partially covering the upper surface of the substrate 11. That is, the interface layer 13 may be provided, for example, in an island shape on the upper surface of the substrate 11. Alternatively, the interface layer 13 may be a continuous layer that partially covers the upper surface of the substrate 11, for example. That is, the interface layer 13 may be provided on the upper surface of the substrate 11 in a mesh shape, for example. In the present modified example, the interface layer 13 preferably covers, for example, 20 % or more, preferably 50 % or more of the plane area of the substrate 11. Note that the plane area of the substrate 11 is the area of the substrate 11 when the substrate 11 is viewed from above in the vertical direction with respect to the upper surface of the substrate 11.

When the interface layer 13 having high conductivity even partially covers the upper surface of the substrate 11, the series resistance between the substrate 11 and the electrode film 12 can be sufficiently reduced. In addition, when the interface layer 13 partially covers the upper surface of the substrate 11 as in the present modified example, the upper surface of the substrate 11 (or the oxide layer 14) and the electrode film 12 can be partially brought into contact with each other. As a result, the effect of improving the adhesion between the substrate 11 and the electrode film 12 can be more easily obtained than in the case where the interface layer 13 is a continuous layer covering the entire upper surface of the substrate 11 as in the above mentioned embodiments. Further, in the present modified example, the time required to provide the interface layer 13 can be shortened, and production cost can also be reduced.

### (Modified example 3)

In the above mentioned embodiments, an example in which the upper surface of the substrate 11 is amorphized during heating in the diamond crystal growth process to provide an amorphous oxide layer 14 is described, but the present disclosure is not limited thereto.

For example, a predetermined annealing process may be performed on the substrate 11 after the scratching treatment. In this way too, the oxide layer 14 can be provided on the upper surface of the substrate 11. Further, for example, the oxide layer 14 may be provided by depositing amorphous silicon oxide (amorphous SiO) or silicon oxide (SiO₂) on the crystal growth surface of the substrate 11 after the scratching treatment. Then, the substrate 11 on which the oxide layer 14 has been provided may be placed into the growth chamber 301 of the hot filament CVD apparatus 300, and by growing diamond crystals by equivalent procedures and conditions to those mentioned above, the interface layer 13 having a high B concentration can be provided between the substrate 11 and the electrode film 12. As a result, equivalent effects to those of the above mentioned embodiments can be obtained.

In the present modified example as well, the oxide layer 14 including Si crystal grains dispersed in the matrix phase thereof can be obtained by performing a predetermined annealing process or depositing amorphous SiO on the substrate 11 having undergone a predetermined scratching treatment.

### (Modified Example 4)

In the above mentioned embodiments, an example in which the SiB layer 15 is provided in the diamond crystal growth process is described, but the present disclosure is not limited thereto. For example, the SiB layer 15 may be provided by depositing silicon boride (SiB) such as silicon tetraboride (SiB₄) on the upper surface of the oxide layer 14.

### (Modified Example 5)

In the above mentioned embodiments, an example in which a predetermined scratching treatment is performed on the crystal growth surface of the substrate 11 is described, but the present disclosure is not limited thereto.

For example, seeding treatment may be performed instead of or in addition to scratching treatment. The seeding treatment is, for example, a treatment in which a solution (dispersion) in which diamond particles (preferably diamond nanoparticles) of about several nm to several tens of µm are dispersed is applied to the crystal growth surface, or the substrate 11 is immersed in this dispersion, to adhere the diamond particles (seeds) to the crystal growth surface. The substrate 11 having undergone the seeding treatment or the substrate 11 having undergone both the scratching treatment and the seeding treatment is placed into the growth chamber 301 of the hot filament CVD apparatus 300, and diamond crystals are grown by an equivalent procedure and under equivalent conditions to the above mentioned procedure and treatment conditions; thus, the interface layer 13 having a high B concentration can be provided between the substrate 11 and the electrode film 12. As a result, equivalent effects to those of the above mentioned embodiments can be obtained.

When only the seeding treatment is performed (that is, when the scratching treatment is not performed), the oxide layer 14 can be provided on the substrate 11, but it is difficult to incorporate Si crystal grains in the oxide layer 14. From the viewpoint of incorporating Si crystal grains in the oxide layer 14, it is preferable to perform a predetermined scratching treatment on the substrate 11.

### (Modified Example 6)

In the above mentioned embodiments, an example in which the oxide layer 14, the SiB layer 15, the interface layer 13, and the electrode film 12 are provided on the substrate 11 in this order is described, but the present disclosure is not limited thereto.

The stack 10 may include at least the substrate 11, the interface layer 13, and the electrode film 12. That is, the stack 10 may not include the oxide layer 14 and the SiB layer 15. When at least the interface layer 13 having a high B concentration is provided between the substrate 11 and the electrode film 12, the series resistance between the substrate 11 and the electrode film 12 can be reduced.

### <Other Embodiments>

Embodiments of the present disclosure are specifically described above. However, the present disclosure is not limited to the above mentioned embodiments, and various modified examples may be made without departing from the scope of the present disclosure.

For example, a functional membrane that transmits only a predetermined detection target (e.g., uric acid) or a functional membrane that reacts only with the detection target may be provided on the electrode film 12. As such a functional membrane, for example, a predetermined surface decoration membrane such as an ion exchange membrane or a membrane containing a predetermined enzyme corresponding to the component to be detected may be provided.

Further, in the above mentioned embodiments and modified examples, an example in which the test liquid is human urine and the detection target is uric acid is described, but the present disclosure is not limited thereto. The test liquid may be a liquid containing a protein such as a body fluid, blood, or urine of an animal including a human. That is, the sensor 30 (stack 10) may be used by bringing a test fluid including body fluid, blood, or urine of an animal including a human into contact with the electrode film 12. For the detection target, when the voltage applied to the electrode group (at least between the stack 10 and the counter electrode 37) is within a predetermined voltage range, the concentration of various components (substances) other than uric acid can be measured by appropriately changing the voltage sweep condition of cyclic voltammetry.

In the above mentioned embodiments and modified examples, the sensor 30 that measures the concentration of the detection target in the test liquid by the three-electrode method is described. However, the present disclosure is not limited thereto. The sensor 30 may be configured to measure the concentration of the detection target in the test liquid by a two-electrode method. That is, the reference electrode 36 and the wire 33 may not be provided.

Further, in the above mentioned embodiments and modified examples, an example in which the stack 10 is used as the working electrode of the sensor 30 is described, but the present disclosure is not limited thereto. The stack 10 according to the present disclosure can be suitably used not only for the working electrode of the sensor 30 but also for an electrode (electrolytic electrode) used for electrochemical electrolytic treatment such as water treatment or sewage treatment (waste liquid treatment), an electrode (ozone generation electrode) used for electrochemical ozone generation treatment, and the like. As mentioned above, in the stack 10, since the series resistance between the substrate 11 and the electrode film 12 is low, more current caused by the electrochemical reaction generated on the surface of the electrode film 12 can be extracted from the substrate 11 side. As a result, when the stack 10 is used as an electrode for performing water treatment, waste liquid treatment, or the like, the speed of water treatment, waste liquid treatment, or the like can be increased, and when the stack 10 is used as an ozone generating electrode, the ozone generation amount can be increased.

### EXAMPLES

Hereinafter, experimental results for confirming the effects of the above mentioned embodiments will be described.

### <Evaluation of Interface Layer and Oxide Layer>

The effect of interposing an interface layer having a high B concentration and the effect of interposing an oxide layer were evaluated.

### (Sample 1)

With Sample 1, a 6-inches single crystal Si substrate having a circular shape in a plan view was prepared as a substrate, and a predetermined scratching treatment was performed on the crystal growth surface of the Si substrate. The Si substrate after the scratching treatment was placed into the growth chamber of the hot filament CVD apparatus illustrated in FIG. 4. Then, heating of the Si substrate (heating of the tungsten filament) was started. At this time, the rate of temperature increase of the tungsten filament was set to be higher than the range described in the above mentioned embodiments. After the temperature of the Si substrate reached a predetermined temperature (diamond crystal growth temperature), the supplies of TMB gas and CH₄ gas were started. The other processing conditions were within the range of the processing conditions described in the above mentioned embodiments. In this way, a stacked substrate was obtained in which the Si substrate and the electrode film constituted from the diamond crystals containing B were provided in this order.

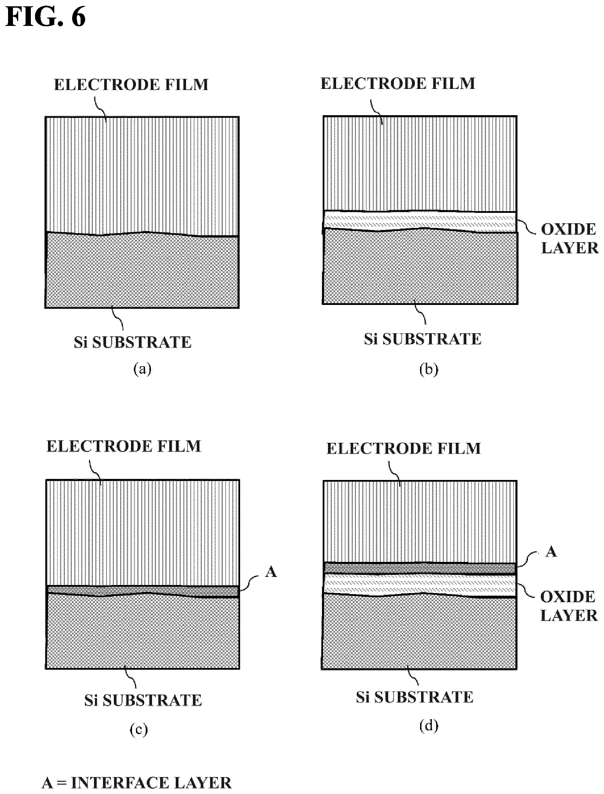

Then, using a galvano optical laser, a laser beam was radiated onto the back surface (surface opposite to the surface on which the electrode film was provided) of the obtained stack under the following laser beam irradiation conditions, to provide laser-processed grooves (concave grooves) in a lattice shape with a pitch of 2 mm. Then, breaking was performed along the laser-processed grooves under the following breaking conditions to obtain a stack (electrode chip) having a size of 2 mm square. This stack was used as Sample 1 (see FIG. 6(a)).

### <Laser Beam Irradiation Conditions>

Laser beam: 532 nm, 5 W, 10 kHz, spot diameter 2 µm
Scanning speed: 10 cm/sec
Number of scans: 4

### <Breaking Conditions>

Amount of break indentation: 0.1 mm
Break Rate: 100 mm/s

### (Sample 2)

With Sample 2, the condition for the scratching treatment is different from that of Sample 1. Except for the condition for the scratching treatment, diamond crystals were grown on the Si substrate under equivalent treatment conditions and treatment procedures to those of Sample 1. In this way, a stacked substrate was obtained in which the Si substrate, the oxide layer, and the electrode film constituted from the diamond crystals containing B were provided in this order. Then, the obtained stack was irradiated with a laser beam and subjected to breaking with equivalent laser beam irradiation conditions, breaking conditions, and procedures to those in Sample 1 to obtain a stack (electrode chip) having a size of 2 mm square. This stack was used as Sample 2 (see FIG. 6(b)).

### (Sample 3)

With Sample 3, a 6-inches single crystal Si substrate having a circular shape in a plan view was prepared as a substrate, and a predetermined scratching treatment was performed on the crystal growth surface of the Si substrate. The Si substrate after the scratching treatment was placed into the growth chamber of the hot filament CVD apparatus illustrated in FIG. 4. Then, heating of the tungsten filament was started, and heating of the Si substrate was started. At this time, the temperature of the tungsten filament was controlled so that the temperature of the tungsten filament gradually increased at a predetermined rate within the range in the above mentioned embodiments until the temperature of the Si substrate reached the diamond crystal growth temperature. After the lapse of a predetermined time from the start of heating of the Si substrate, at a timing before the temperature of the Si substrate reached the first pyrolysis temperature, the supplies of the H₂ gas, the TMB gas, and the CH₄ gas into the growth chamber were started. When the temperature of the Si substrate approaches the first pyrolysis temperature, the decomposition of the TMB gas gradually starts, and when the temperature of the Si substrate becomes equal to or higher than the first pyrolysis temperature, a substantial degree of decomposition of the TMB gas starts. When the temperature of the Si substrate approaches the second pyrolysis temperature, decomposition of the CH₄ gas gradually starts in addition to decomposition of the TMB gas. When the temperature of the Si substrate becomes equal to or higher than the second pyrolysis temperature, a substantial degree of decomposition of the CH₄ gas starts. The other processing conditions were within the range of the processing conditions in the above mentioned embodiments, and were equivalent to those of Sample 1. In this way, a stacked substrate was obtained in which the Si substrate, the interface layer, and the electrode film constituted from the diamond crystals containing B were provided in this order. In this stacked substrate, it was confirmed that the B concentration in the interface layer was higher than the B concentration in the electrode film. Then, laser beam irradiation and breaking were performed on the obtained stacked substrate under equivalent laser beam irradiation condition, breaking condition, and procedure to those of Sample 1 to obtain a stack (electrode chip) having a size of 2 mm square. This stack was used as Sample 3 (see FIG. 6(c)).

### (Sample 4)

With Sample 4, the condition for the scratching treatment is different from that of Sample 3. Except for the condition for the scratching treatment, diamond crystals were grown on the Si substrate under equivalent treatment conditions and treatment procedures to those of Sample 3. In this way, a stacked substrate was obtained in which the Si substrate, the oxide layer, the interface layer, and the electrode film constituted from the diamond crystals containing B were provided in this order. In this stacked substrate, it was confirmed that the B concentration in the interface layer was higher than the B concentration in the electrode film. Then, laser beam irradiation and breaking were performed on the obtained stacked substrate under equivalent laser beam irradiation condition, breaking condition, and procedure to those of Sample 1 to obtain a stack (electrode chip) having a size of 2 mm square. This stack was used as a Sample 4 (see FIG. 6(d)).

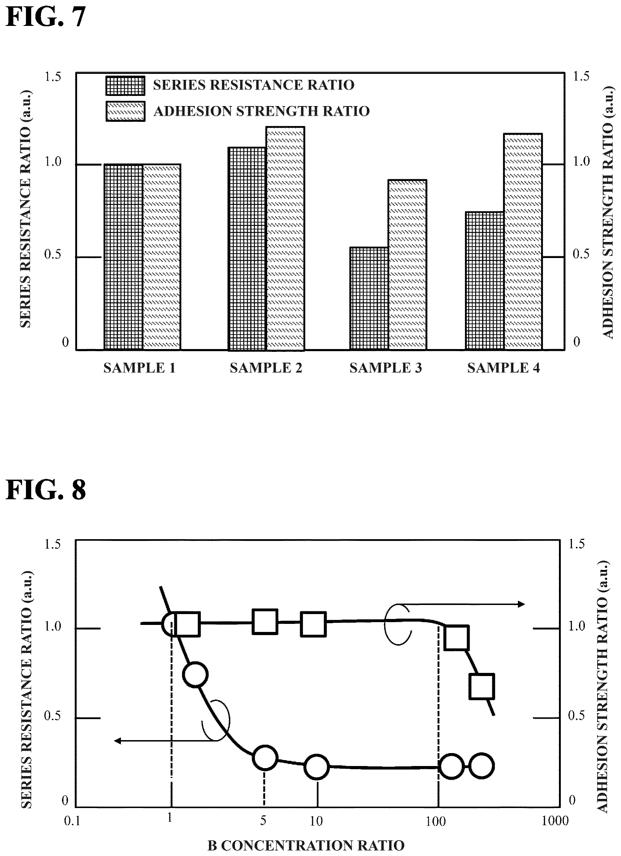

In the electrode chips of Samples 1 to 4, the series resistance (inter-member resistance) between the Si substrate and the electrode film was measured. The series resistance of each sample was normalized by having the series resistance of Sample 1 as "1". The normalized value was defined as a "series resistance ratio". FIG. 7 shows the evaluation results of the series resistances of Samples 1 to 4.

In the electrode chips of Samples 1 to 4, the adhesion strength between the Si substrate and the electrode film was measured by the following method. First, the front and back surfaces of each of the electrode chips of Samples 1 to 4 were bonded to a predetermined tensile test jig using an epoxy-based adhesive. The front surface of the electrode chip means the surface opposite to the surface on the side where the Si substrate is provided among the surfaces of the electrode film, and the back surface of the electrode chip means a surface opposite to the surface on the side where the electrode film is provided among the surfaces of the Si substrate. Then, a tensile test was performed in a state where the front and back surfaces of the electrode chip were bonded to the tensile test jig. In the tensile test, the maximum load when the electrode film was peeled off from the Si substrate was defined as the adhesion strength between the Si substrate and the electrode film. The adhesion strength of each sample was normalized by having the adhesion strength of Sample 1 as "1". The normalized value was defined as an "adhesion strength ratio". FIG. 7 shows the evaluation results of the adhesion strengths of Samples 1 to 4.

From FIG. 7, it can be confirmed that the series resistances of Samples 3 and 4 are lower than that of Sample 1. From this, it can be seen that the series resistance can be reduced by providing the interface layer having the B concentration higher than the B concentration in the electrode film between the Si substrate and the electrode film.

It can also be confirmed from FIG. 7 that the adhesion strength of Sample 4 is higher than that of Sample 3. From this, it can be seen that by providing the oxide layer between the Si substrate and the interface layer, the adhesion between the Si substrate and the interface layer, and thus the adhesion between the Si substrate and the electrode film, can be improved. That is, it can be seen that the adhesion between the Si substrate and the electrode film can be improved while the series resistance is reduced, by providing the oxide layer between the Si substrate and the interface layer.

Further, it can be confirmed from FIG. 7 that an increase in series resistance is suppressed in Sample 4 as compared with Sample 2. From this, it can be seen that an increase in series resistance due to the interposition of the oxide layer having low conductivity can be avoided by providing the interface layer having a high B concentration.

### <Evaluation of B Concentration in Interface Layer>

The correlation between the B concentration in the interface layer and series resistance and the correlation between the B concentration in the interface layer and adhesion strength were evaluated.

A plurality of samples (electrode chips) in each of which a single crystal Si substrate, an interface layer, and an electrode film constituted from diamond crystals containing B were stacked in this order were prepared. The plurality of samples have different B concentrations in the interface layers, specifically, ratios of the B concentration in the interface layers to the B concentration in the electrode films (i.e. B concentration in the interface layers / B concentration in the electrode films, hereinafter also simply referred to as "B concentration ratio"). Each B concentration ratio was adjusted by controlling the supply amount (supply flow rate, partial pressure, etc.) of the B-containing gas, the temperature of the substrate, etc., when growing the diamond crystal.

The series resistance (inter-member resistance) between the Si substrate and the electrode film of each sample was measured. The series resistance of each sample was normalized by having the series resistance of the sample having a B concentration ratio of 1 as "1". The normalized value was defined as a "series resistance ratio". FIG. 8 illustrates an evaluation result of the correlation between the B concentration in the interface layer and the series resistance.

In addition, the adhesion strength between the Si substrate and the electrode film of each sample was measured. The adhesion strength was measured in an equivalent manner to the manner described in the above mentioned "Evaluation of Interface Layer and Oxide Layer". The adhesion strength of each sample was normalized by having the adhesion strength of the sample having a B concentration ratio of 1 as "1". The normalized value was defined as an "adhesion strength ratio". FIG. 8 shows the evaluation results of the correlation between the B concentration in the interface layer and the adhesion strength.

The "sample having a B concentration ratio of 1" means an electrode chip in which the B concentration in the interface layer and the B concentration in the electrode film are the same, that is, a sample having the electrode film directly provided on the Si substrate (sample having no interface layer).

From FIG. 8, it can be confirmed that when the B concentration ratio is more than 1, that is, when the B concentration in the interface layer is higher than the B concentration in the electrode film, the series resistance can be reduced compared to the sample having the B concentration ratio of 1.

Further, from FIG. 8, it can be confirmed that when the B concentration ratio is 2 or more, the series resistance ratio can be reduced to about 0.7. That is, it can be confirmed that when the B concentration in the interface layer is two times or more the B concentration in the electrode film, the effect of series resistance reduction can be remarkably obtained while maintaining the adhesion strength between the Si substrate and the electrode film.

Further, from FIG. 8, it can be confirmed that when the B concentration ratio is 5 or more, the series resistance ratio can be reduced to about 0.3. That is, it can be confirmed that the effect of series resistance reduction can be more remarkably obtained when the B concentration in the interface layer is 5 times or more the B concentration in the electrode film.

Further, from FIG. 8, it can be confirmed that when the B concentration ratio is 100 or less, the adhesion strength ratio can be maintained at about 1. That is, it can be confirmed that when the B concentration in the interface layer is 100 times or less the B concentration in the electrode film, a decrease in the adhesion strength between the Si substrate and the electrode film can be avoided while obtaining the effect of reducing the series resistance.

In addition, the present inventors performed, in the sample having the B concentration ratio of 100 or less, observation of the peeled surface after the tensile test (after the measurement of the adhesion strength) at the time of the measurement of the adhesion strength, and detailed analysis of the cross section (longitudinal cross section) in the thickness direction between the Si substrate and the electrode film. As a result, in the sample having the B concentration ratio of 100 or less, not only the interface layer but also constituent members of the sample such as the substrate and the electrode film were observed on the peeled surface after the adhesion strength measurement. This means that the interface layer was not embrittled and the adhesion strength between the substrate and the interface layer was high.

In addition, from FIG. 8, it can be confirmed that the adhesion strength sharply decreases when the B concentration ratio exceeds 100. In addition, the present inventors performed, in the sample having a B concentration ratio of more than 100, observation of a peeled surface after measurement of the adhesion strength, and detailed analysis of the longitudinal cross section between the Si substrate and the electrode film. As a result, it was confirmed that the interface layer mainly appeared on the peeled surface after the adhesion strength measurement in the sample having the B concentration ratio exceeding 100. This means that the interface layer was embrittled and the adhesion strength between the substrate and the interface layer was low. From these results, it was found that when the B concentration in the interface layer exceeds 100 times the B concentration in the electrode film, the interface layer is embrittled, and the adhesion between the Si substrate and the electrode film decreases.

### <Evaluation of Si Crystal Grain Density in Oxide Layer>

A correlation between the Si crystal grain density in the oxide layer (hereinafter also referred to as "Si crystal grain density") and series resistance and the correlation between the Si crystal grain density and adhesion strength were evaluated.

A plurality of samples (electrode chips) were prepared, in each of which a single crystal Si substrate, an oxide layer, an interface layer, and an electrode film constituted from diamond crystals containing B were stacked in this order, and the B concentration in the interface layer is higher than the B concentration in the electrode film. The plurality of samples have different Si crystal grain densities in the oxide layer. The Si crystal grain density was adjusted by changing the conditions of the scratching treatment performed on the Si substrate.

The Si crystal grain density was determined on the assumption that the form of distribution of Si crystal grains obtained by observing the longitudinal cross section (cross section in the thickness direction) of the interface layer by TEM also continues in the depth direction of the longitudinal cross section.

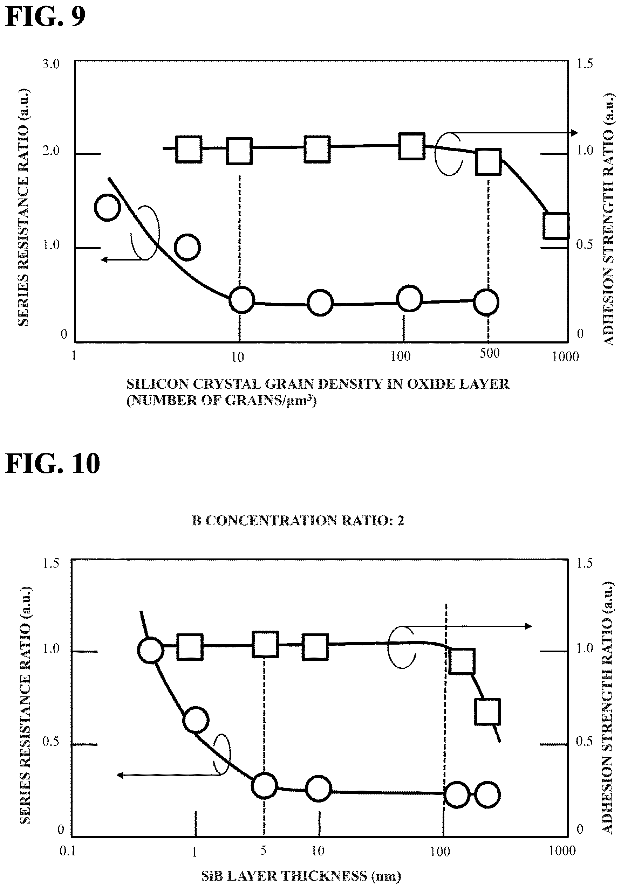

The series resistance (inter-member resistance) between the Si substrate and the electrode film of each sample was measured. The series resistance of each sample was normalized by having the series resistance of a sample having a Si crystal grain density of 5 grains/µm³ as "1". The normalized value was defined as a "series resistance ratio". FIG. 9 shows the evaluation results of the correlation between the Si crystal grain density in the oxide layer and the series resistance.

In addition, the adhesion strength between the Si substrate and the electrode film of each sample was measured. The adhesion strength was measured in an equivalent manner to that described in the above mentioned "Evaluation of Interface Layer and Oxide Layer". The adhesion strength of each sample was normalized by having the adhesion strength of the sample having a Si crystal grain density of 5 grains/µm³ as "1". The normalized value was defined as an "adhesion strength ratio". FIG. 9 shows the evaluation results of the correlation between the Si crystal grain density in the oxide layer and the adhesion strength.

From FIG. 9, it can be confirmed that when the Si crystal grain density is 10 grains/µm³ or more, the series resistance ratio can be reduced to about 0.5. That is, it can be seen that when the Si crystal grain density is 10 grains/µm³ or more, an increase in series resistance due to the interposition of the oxide layer can be avoided.

Further, from FIG. 9, it can be confirmed that when the Si crystal grain density is 500 grains/µm³ or less, the adhesion strength ratio can be maintained at approximately 1 (around 1). That is, it can be seen that when the Si crystal grain density is 500 grains/µm³ or less, an increase in series resistance due to the interposition of the oxide layer can be avoided while maintaining the adhesion strength.

In addition, the present inventors performed, in a sample having a Si crystal grain density of 500 grains/µm³ or less, observation of a peeled surface after measurement of the adhesion strength, and detailed analysis of the longitudinal cross section between the Si substrate and the electrode film. As a result, in the sample having a Si crystal grain density of 500 grains/µm³ or less, not only the oxide layer but also each of the constituent members of each sample such as the Si substrate, the interface layer, and the electrode film was observed on the peeled surface after the measurement of the adhesion strength. This means that the oxide layer was not embrittled and the adhesion between the Si substrate and the electrode film was high.

Further, from FIG. 9, it can be confirmed that when the Si crystal grain density exceeds 500 grains/µm³, the adhesion strength sharply decreases. The present inventors performed, in a sample having a Si crystal grain density exceeding 500 grains/µm³, observation of the peeled surface after the measurement of the adhesion strength, and detailed analysis of the longitudinal cross section between the Si substrate and the electrode film. As a result, it was confirmed that the oxide layer mainly appeared on the peeled surface after the adhesion strength measurement, that is, the oxide layer was embrittled in the sample having a Si crystal grain density exceeding 500 grains/µm³. From these results, it was found that when the Si crystal grain density in the oxide layer exceeds 500 grains/µm³, the oxide layer is embrittled, and the adhesion between the Si substrate and the electrode film is lowered.

### <Evaluation of SiB layer thickness>

The correlation between the SiB layer thickness and series resistance and the correlation between the SiB layer thickness and adhesion strength were evaluated.

A plurality of samples (electrode chips) were prepared in which a single crystal Si substrate, an oxide layer, a SiB layer, an interface layer, and an electrode film constituted from diamond crystals containing B were stacked in this order, and the B concentration in the interface layer was twice the B concentration in the electrode film (the B concentration ratio was 2). In a plurality of samples, the SiB layer thicknesses are different. The SiB layer thickness was adjusted by controlling the temperature rise rate of the substrate (tungsten filament) when growing the diamond crystal.

The series resistance (inter-member resistance) between the Si substrate and the electrode film of each sample was measured. The series resistance of each sample was normalized by having the series resistance of a sample having a SiB layer thickness of 0.6 nm as "1". The normalized value was defined as a "series resistance ratio". FIG. 10 shows evaluation results of the correlation between the SiB layer thickness and the series resistance.

In addition, the adhesion strength between the Si substrate and the electrode film of each sample was measured. The adhesion strength was measured in an equivalent manner to that described in the above-mentioned "Evaluation of Interface Layer and Oxide Layer". Then, the adhesion strength of each sample was normalized by having the adhesion strength of a sample having a SiB layer thickness of 0.6 nm as "1". The normalized value was defined as an "adhesion strength ratio". FIG. 10 shows the evaluation results of the correlation between the SiB layer thickness and the adhesion strength.

From FIG. 10, it can be confirmed that when the SiB layer thickness is 1 nm, the series resistance ratio can be reduced to about 0.6. From this, it can be confirmed that a capacitive coupling effect or a tunneling effect is generated between the Si substrate and the SiB layer by providing the SiB layer having a thickness of 1 nm or more, and sandwiching the oxide layer between the Si substrate and the SiB layer having high conductivity. That is, it can be seen that when the SiB layer thickness is 1 nm or more, an increase in series resistance due to the interposition of the oxide layer can be avoided.

Further, from FIG. 10, it can be confirmed that when the SiB layer thickness is 5 nm or more, the series resistance ratio can be reduced to about 0.3 (0.3 or less). From this, it can be seen that when the SiB layer thickness is 5 nm or more, an increase in series resistance due to the interposition of the oxide layer can be reliably avoided.

Further, from FIG. 10, it can be confirmed that when the SiB layer thickness is 100 nm or less, the adhesion strength ratio can be maintained at approximately 1 (around 1). That is, it can be seen that when the SiB layer thickness is 100 nm or less, an increase in series resistance due to the interposition of the oxide layer can be avoided while maintaining the adhesion strength.

Further, from FIG. 10, it can be confirmed that when the SiB layer thickness exceeds 100 nm, the adhesion strength sharply decreases.

### <Preferable Aspects of the Present Disclosure>

Preferable aspects of the present disclosure will be supplementarily described hereafter.

### <Supplementary description 1>

According to an aspect of the present disclosure, there is provided an electrode-use stack structure including:
a substrate having conductivity; and
an electrode film provided on one main surface from among two main surfaces of the substrate and constituted from a diamond crystal containing boron,
wherein an interface layer containing carbon as a main component and containing boron is provided between the substrate and the electrode film, and
the interface layer has a boron concentration higher than a boron concentration in the electrode film.

### <Supplementary description 2>

The structure according to Supplementary description 1,
wherein, preferably the interface layer has a π bond.

### <Supplementary description 3>

The structure according to either one of Supplementary descriptions 1 and 2,
wherein, preferably a π bond density in the interface layer is higher than a π bond density in the electrode film.

### <Supplementary description 4>

The structure according to any one of Supplementary descriptions 1 to 3,
wherein, preferably an oxide layer containing a main element constituting the substrate and oxygen is provided between the substrate and the interface layer.

### <Supplementary description 5>

The structure according to any one of Supplementary descriptions 1 to 4,
wherein, preferably the substrate contains silicon as a main element constituting the substrate, and an amorphous oxide layer containing silicon and oxygen is provided between the substrate and the interface layer.

### <Supplementary description 6>

The structure according to Supplementary description 4 or 5,
wherein, preferably a layer containing the main element (silicon in the case of Supplementary description 5) and boron and containing no oxygen is provided on a surface of the oxide layer, this surface being in contact with the interface layer.

### <Supplementary description 7>

The structure according to any one of Supplementary descriptions 4 to 6,
wherein, preferably the oxide layer contains crystal grains of the main element (silicon in the case of Supplementary description 5) dispersed in a matrix phase of the oxide layer.

### <Supplementary description 8>

The structure according to any one of Supplementary descriptions 1 to 7,
wherein, preferably the interface layer is a continuous layer covering the entirety of the one main surface of the substrate.

### <Supplementary description 9>

The structure according to any one of Supplementary descriptions 1 to 7,
wherein, preferably the interface layer is either a discontinuous layer partially covering the one main surface of the substrate or a continuous layer partially covering the one main surface of the substrate.

### <Supplementary description 10>

The structure according to Supplementary description 9,
wherein, preferably the interface layer covers 20 % or more, preferably 50 % or more, of the area of the one main surface of the substrate when the one main surface is viewed from above in a vertical direction.

### <Supplementary description 11>

According to another aspect of the present disclosure, there is provided a method of manufacturing an electrode-use stack structure, the method including:
<a> preparing a substrate having conductivity;
<b> providing an interface layer on the substrate, the interface layer containing carbon as a main component and containing boron; and
<c> providing an electrode film on the interface layer, the electrode film comprising a diamond crystal containing boron,
wherein a boron concentration in the interface layer is set to be higher than a boron concentration in the electrode film.

### <Supplementary description 12>

The method according to Supplementary description 11,
wherein, preferably:
the <a> includes placing the substrate into a growth chamber, the growth chamber being configured to be capable of receiving supply of a boron-containing gas having a first pyrolysis temperature and a carbon-containing gas having a second pyrolysis temperature higher than the first pyrolysis temperature;
the <b> includes providing the interface layer on the substrate by supplying the boron-containing gas and the carbon-containing gas into the growth chamber under a predetermined temperature condition higher than the first pyrolysis temperature and lower than the second pyrolysis temperature; and
the <c> includes providing the electrode film on the interface layer by supplying the boron-containing gas and the carbon-containing gas into the growth chamber under a predetermined temperature condition equal to or higher than the second pyrolysis temperature.

### <Supplementary description 13>

The method according to either one of Supplementary description 11 or 12,
wherein, preferably the method further includes <d> providing, on the substrate, an oxide layer containing a main element constituting the substrate and oxygen, the <d> being carried out before the <b>.

### <Supplementary description 14>

The method according to Supplementary description 13,
wherein, preferably the method further includes <e> providing, on an outermost surface of the oxide layer, a layer containing the main element and boron and containing no oxygen, the <e> being carried out after the <d> and before the <b>.

### <Supplementary description 15>

The method according to Supplementary description 13 or 14,
wherein, preferably the <b> and the <c> are carried out under a condition under which the oxide layer is not crystallized but is amorphized.

### DESCRIPTION OF SIGNS AND NUMERALS

- 10: electrode-use stack structure (stack)
- 11: Substrate
- 12: Electrode film
- 13: Interface layer
- 30: Electrochemical sensor

## Claims

1. An electrode-use stack structure comprising:
a substrate having conductivity; and
an electrode film provided on one main surface from among two main surfaces of the substrate and constituted from a diamond crystal containing boron,
wherein an interface layer containing carbon as a main component and containing boron is provided between the substrate and the electrode film, and
the interface layer has a boron concentration higher than a boron concentration in the electrode film.

2. The electrode-use stack structure according to Claim 1,
wherein the interface layer has a π bond.

3. The electrode-use stack structure according to either one of Claims 1 and 2,
wherein a π bond density in the interface layer is higher than a π bond density in the electrode film.

4. The electrode-use stack structure according to any one of Claims 1 to 3,
wherein, an oxide layer containing a main element constituting the substrate and oxygen is provided between the substrate and the interface layer.

5. The electrode-use stack structure according to Claim 4,
wherein a layer containing the main element and boron and containing no oxygen is provided on a surface of the oxide layer, this surface being in contact with the interface layer.

6. The electrode-use stack structure according to Claim 4 or 5,
wherein the oxide layer contains crystal grains of the main element dispersed in a matrix phase of the oxide layer.

7. A method of manufacturing an electrode-use stack structure, the method comprising:
<a> preparing a substrate having conductivity;
<b> providing an interface layer on the substrate, the interface layer containing carbon as a main component and containing boron; and
<c> providing an electrode film on the interface layer, the electrode film comprising a diamond crystal containing boron,
wherein a boron concentration in the interface layer is set to be higher than a boron concentration in the electrode film.

8. The method of manufacturing an electrode-use stack structure according to Claim 7,
wherein the <a> includes placing the substrate into a growth chamber, the growth chamber being configured to be capable of receiving supply of a boron-containing gas having a first pyrolysis temperature and a carbon-containing gas having a second pyrolysis temperature higher than the first pyrolysis temperature,
the <b> includes providing the interface layer on the substrate by supplying the boron-containing gas and the carbon-containing gas into the growth chamber under a predetermined temperature condition higher than the first pyrolysis temperature and lower than the second pyrolysis temperature, and
the <c> includes providing the electrode film on the interface layer by supplying the boron-containing gas and the carbon-containing gas into the growth chamber under a predetermined temperature condition equal to or higher than the second pyrolysis temperature.

9. The method of manufacturing an electrode-use stack structure according to Claim 7 or 8, the method further comprising <d> providing, on the substrate, an oxide layer containing a main element constituting the substrate and oxygen, the <d> being carried out before the <b>.

10. The method of manufacturing an electrode-use stack structure according to Claim 9, the method further comprising <e> providing, on an outermost surface of the oxide layer, a layer containing the main element and boron and containing no oxygen, the <e> being carried out after the <d> and before the <b>.

11. The method of manufacturing an electrode-use stack structure according to Claim 9 or 10, wherein the <b> and the <c> are carried out under a condition under which the oxide layer is not crystallized but is amorphized.
